# NEUE EUROPÄISCHE PATENTSCHRIFT

(11) **EP 0 299 371 B2**
(45) Veröffentlichungstag und Bekanntmachung des Hinweises auf die Entscheidung über den Einspruch: **08.09.1999**
(45) Hinweis auf die Patenterteilung: 07.10.1992
(21) Anmeldenummer: 88110906.0
(22) Anmeldetag: 08.07.1988
(51) Int. Cl.: G04C 10/00

(54) **Batteriekammer-Verschluss, insbesondere für Armbanduhren**
Shutter for a battery housing, in particular for wrist watches
Fermeture pour compartiment de pile, en particulier pour montres-bracelets

(30) Priorität: 11.07.1987 DE 8709588 U
(43) Veröffentlichungstag der Anmeldung: 18.01.1989
(73) Patentinhaber: JUNGHANS UHREN GMBH, 78713 Schramberg (DE)
(72) Erfinder: Riis, Peter, D-7212 Deisslingen (DE); Ganter, Wolfgang, D-7230 Schramberg (DE)
(74) Vertreter: Hofmann, Gerhard, Dipl.-Ing. Patentassessor

(56) Entgegenhaltungen:
- EP-A- 0 177 085
- AU-A- 6 557 986
- CH-A- 335 610
- GB-A- 2 178 561
- US-A- 4 166 359
- US-A- 4 182 020
- PATENT ABSTRACTS OF JAPAN, vol. 3, no. 121 (E-143), 11th October 1979 & JP-A-54 98 670

## Beschreibung

Die Erfindung betrifft einen Verschluß gemäß dem Oberbegriff des Anspruches 1.

Ein solcher Verschluß ist aus der US-PS 4 166 359 bekannt. Er weist bei seinem Stopfen eine Hinterschneidung am Übergang von seinem Kragen zum eigentlichen, in die Öffnung einzusetzenden, Steckteil auf, mit Abdichtung der verschlossenen Öffnung durch einen elastischen Ring zwischen jener Hinterschneidung und der zum Kragen hin konisch sich aufweitenden Batteriekammer-Öffnung. Eine unmittelbare radiale Dichtpressung zwischen dem Rand der Öffnung und dem Stopfen findet erst beim vom Kragen abgelegenen freien Stirnende des Steckteiles statt. Abgesehen vom relativ hohen Fertigungsaufwand für die Herstellung eines Stopfens mit der Kragen-Hinterschneidung und vom hohen Montageaufwand hinsichtlich des gesondert beizustellenden und einzulegenden elastischen Dichtringes unter dem Kragen weist jene vorbekannte Lösung den funktio-nellen Nachteil nur geringer radialer Dichtkräfte auf, weil kein Stützmaterial jenseits des Steckteil-Stirnendes, also jenseits der radialen Dichtebene zwischen Öffnung und Stopfen, vorhanden ist. Auch ist die Handhabung beim Einsetzen dieses Stopfens insofern mit funktionellen Nachteilen behaftet, als der zusätzlich einzulegende Dichtring sich verkanten kann und dann kein rundum gleichförmiger Eingriff, also keine gleichförmige Dichtwirkung gewährleistet ist.

Da das Steckteil des Stopfens bei der vorbekannten Ausführung nicht über die Stärke der Bodenöffnung hinausragt, sind für die axiale Halterung der durch diese Öffnung auszutauschenden Batterie zusätzliche Maßnahmen erforderlich, was die Fertigungs- und Montagekosten weiter erhöht.

Aus der DE-PS 21 39 590 ist für die rückwärtige Abstützung einer Batterie mit gleichzeitigem Verschluß der Batterieaustauschöffnung eine Scheibe bekannt, die in einen nufförmigen, in der Öffnung umlaufenden Wandungs-Einstich eingesprengt werden können soll. Eine solche Auslegung der Öffnungswandung bedingt aber erheblichen fertigungstechnischen Aufwand; und ein hermetischer, insbesondere wasserdichter, Verschluß der Batterieöffnung ist schon deshalb dadurch nicht erreicht, weil die Scheibe mit der Fingerspitze verdrehbar in der umlaufenden Ringnut gehaltert sein soll. Da für das Einsprengen der Scheibe eine Durchbiegung erforderlich ist, kommt eine unmittelbare Abstützung gegenüber der Rückseite der Batterie nicht in Betracht, es sei denn die Batterie ist axial federnd gehaltert. Die Demontage einer solchen radial eingesprengten Scheibe dürfte kaum ohne weiteres, zumindet nicht ohne Beschädigungen an der Scheibe und an der Öffnung, möglich sein - so daß eine Wiederverwendung nach dem Batterieaustausch ausgeschlossen erscheint.

In Erkenntnis dieser Gegebenheiten und Mängel liegt der Erfindung die Aufgabe zugrunde, eine wiederholt benutzbaren Stopfen zum hermetisch dichten, jedenfalls wasserdichten, Verschließen einer Batterieaustausch-Öffnung zu schaffen, der nicht nur zugleich Positionierfunktionen für die Batterie übernimmt und preisgünstig herstellbar ist, sondern insbesondere auch im Interesse gesteigerten Gebrauchszweckes eine manuell leichte und funktionssichere Handhabung im Zuge eines Batterietausches ermöglicht.

Diese Aufgabe wird erfindungsgemäß im wesentlichen dadurch gelöst, daß der gattungsgemäße Stopfen gemäß dem Kennzeichnungsteil des Anspruches 1 ausgelegt ist.

Diese Lösung stellt einen (mangels Hinterschnitt-Notwendigkeit) einfach fertigbaren und (mangels Erfordernisses zusätzlich beizustellender Dichtungsteile) einfach montierbaren, selbstdichtenden und Stützfunktionen für die Batterie mit-übernehmenden Batteriedeckel dar, indem er als axial flaches, längs einer radial umlaufenden Dichtkante einspannbares Kunststoff-Schnappteil ausgelegt ist. Da der Schnappvorgang dem Bediener die Gewißheit gibt, daß dieser stopfenförmige Deckel korrekten Sitz erfahren hat, kommen Fehlmontagen und daraus resultierende Undichtigkeiten, also Betriebs-Funktionsstörungen praktisch nicht mehr vor. Dabei beruht diese funktionsunkritische Handhabbarkeit auf dem Auftreten einer Kraftumkehr (im Zuge des Eindrückens des flachzylindrischen Stopfens in die Batteriekammer-Öffnung eines Uhrgehäuses), die zugleich eine radiale Verspannung, und damit eine über herkömmliche Reibungs- und Umformkräfte hinausgehende Dichtfunktion, zwischen dem Rand der Batterieöffnung und dem Verschlußdeckel-Stopfen erbringt. Der Stopfen kann einstückig aus elastischem Kunststoff gespritzt sein und axial so dimensioniert werden, daß er hinreichend weit durch die Batteriekammer-Öffnung ins Innere hineinragt, um dort axiale Stützfunktionen für die Batterie gleich mit zu übernehmen.

Trotz flacher Ausbildung des Stopfens insgesamt wird also ein im Zuge des Eindrückens in die Öffnung deutlich wahrnehmbarer und große radiale Dichtkräfte erzeugender Umschnappvorgang erzielt; zumal wenn noch auf der Betätigungsseite in die Oberfläche eine als Endruckfläche dienende, sich etwa über die Kragendicke erstreckende Ausnehmung eingeformt ist.

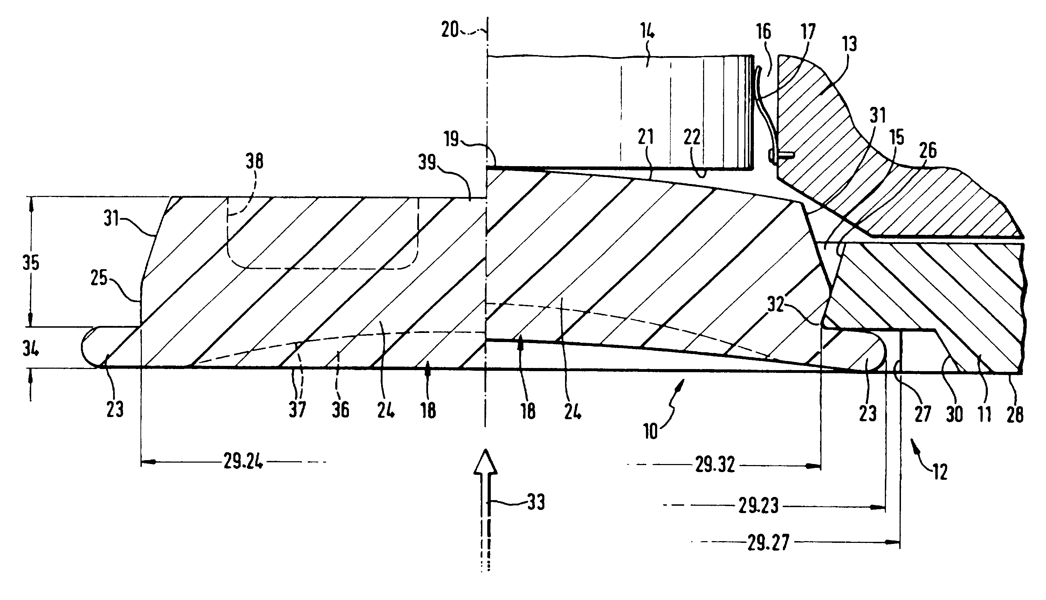

Zusätzliche Alternativen und Weiterbildungen sowie weitere Merkmale und Vorteile der Erfindung ergeben sich aus den weiteren Ansprüchen und, auch unter Berücksichtigung der Darlegungen in der Zusammenfassung, aus nachstehender Beschreibung eines in der Zeichnung unter Beschränkung auf das Wesentliche stark abstrahiert aber angenähert maßstabsgerecht vergrößert skizzierten bevorzugten Realisierungsbeispiels zur erfindungegemäßen Lösung. Die einzige Figur der Zeichnung zeigt im Axial-Längsschnitt bei abgebrochener Darstellung die rechte Hälfte des Verschluß-Stopfens in seiner kraftschlüssig in eine Gehäuseöffnung dicht eingesprengten Position; und zum Vergleich dazu daneben die linke Stopfen-Hälfte in mechanisch unbeanspruchter, entspannter Form.

Das dargestellte Ausführungsbeispiel eines wieder-öffnenbaren Batteriekammer-Verschlusses 10 zeigt in abgebrochener Schnittdarstellung den Boden 11 einer Armbanduhr 12. In deren Gehäuse ist, in nicht näher dargestellter Weise (vgl. z.B. DE-OS 34 21 168), ein elektromechanisches Uhrwerk 13 gehaltert, das seine Betriebsenergie aus einer elektrochemischen Sekundärquelle in der Bauform einer Knopf-Batterie 14 bezieht. Diese ist durch eine Austauschöffnung 15 im Boden 11 hindurch, ohne das Uhrwerk 13 dafür herausnehmen zu müssen, austauschbar. Die mechanische Positionierung und Halterung der Batterie 14 samt ihrer elektromechanischen Kontaktierung erfolgt in einer rückwärtig im Uhrwerk 13 und zum Boden 11 hin offenen Batteriekammer 16 mittels einer oberen (der Öffnung 15 gegenüberliegenden, in der Zeichung nicht berücksichtigten) und einer seitlich anliegenden Kontaktfeder 17.

Die rückwärtige Abstützung der Batterie 14 unter gleichzeitigem (auch nach wiederholtem Öffnen noch) hermetisch dichtem (wasserdichtem)-Abschluß der Bodenöffnung 15 erfolgt mittels eines steifelastischen, im Mittenlängsschnitt etwa flachhutförmig konfigurierten Kunststoff-Verschlußstopfens 18. Dieser liegt mit dem Mittenbereich 19 ( der abweichend vom zeichnerisch dargestellten Ausführungsbeispiel bei exzentrisch gelegener Batteriekammer 16 nicht mit der Uhren-Mittenlängsachse 20 zusammenfallen muß) seiner oberen Stirnfläche 21 gegen die dem Gehäuseboden 11 der Armbanduhr 12 zugewandte Rückseite 22 der Batterie 14 an; während der direkt über dem Kra- gen 23 sich zylindrisch anschließende Steckteil 24 unter radialer Stauchung seiner Mantelfläche 25 in Eingriff steht mit einer Dichtkante 32, ausgebildet an einer in die Bodenöffnung 15 umlaufend vorste- henden Rampe 26. Oberhalb der in die Stopfen- Mantelflache 25 eindrückenden Rampe 26 erfährt die Bodenöffnung 15 also eine Aufweitung. Unter- halb dieser rippenförmig umlaufenden Rampe 26 geht die Bodenöffnung 15 in einen umlaufenden, ringförmigen Einstich 27 in die Bodenfläche 28 über, dessen Durchmesser 29.27 etwas größer ist als der lichte Außendurchmesser 29.23 des Stopfen-Kragens 23. Entsprechend ist die axiale Tiefe des Einstiches 27 vorzugsweise etwas größer gewählt als die Dicke des Kragens 23, damit auch in eingewölbtem Zustand möglichst kein Überstand über die Bodenfläche 28 auftritt. Um den Verschlußstopfen 18 leicht aus der Bodenöffnung 15 heraushebeln zu können, ist zum Ansatz eines Werkzeugs an wenigstens einer Umfangsstelle des Einstiches 27 eine über dessen Peripherie radial hinaus sich erstreckende Abschrägung 30 vorgesehen. Als Einführhilfe weist das an sich zylindrische Steckteil 24 des Stopfens 18 dem Kragen 23 gegenüber eine konische Verjüngung 31 auf.

Die Abdichtung des Verschlusses der Batteriekammer-Bodenöffnung 15 wird also durch die elastische Verformung des Stopfenmaterials gegenüber der die Dichtkante 32 bildenden Rampe 26 infolge der radialen Reaktionskräfte erreicht, die beim Ausbeulen des Verschlußstopfens 18 von der Bodenfläche 28 fort zum Gehäuseinnern, also zur Batterie 14 hin auftreten.

Dieser Ausbeulvorgang vollzieht sich nach Maßgabe der Lage der Angriffsebene der RampenDichtkante 32, immer in die Richtung größerer Höhe bezüglich dieser Angriffsebene. Daraus resultiert, daß der flache Stopfen 18 zu einer Wölbung nach außen, also hinter die Ebene der Bodenfläche 28, tendiert, wenn sein Steckteil einführungsseitig, also im Bereiche der Einführ-Verjüngung 31, beim Eindrücken radial von der Dichtkante 32 beansprucht wird. Wenn die Druckbeaufschlagung 33 zu tieferem Eingriff des Steckteiles 24 in die umlaufende Rampe 26 führt, verlagert sich die durch die Dichtkante 32 definierte Querschnittsebene zunehmend zur Höhen-Mitte des Stopfens 18 hin und dann über diese hinaus, so daß schließlich der größere Höhenanteil des Stopfens 18 über der Ebene der Dichtkante 32 liegt. Dieser Übergang führt zu einem Umschlagen der Auswölbungs-Tendenz, nun also (wie zeichnerisch dargestellt) ins Gehäuseinnere der Uhr 12 hinein (mit Begrenzung durch axiale Stütz-Anlage gegen die Batterie-Rückseite 22). Indem also die Dicke 34 des Stopfen-Kragens 23 spürbar geringer gewählt ist, als die Höhe 35 des Stopfen-Steckteiles 24, führt das Eindrücken des Dichtstopfens 28 in die Batterieaustausch-Bodenöffnung 15 bis zum Kragen-Anschlag zu einem an der Fingerspitze deutlich spürbaren Umschnapp-Vorgang; der dem Handelnden die Gewißheit Vermittelt, daß der Bodenstopfen 18 nun seinen korrekten und dichten Sitz erzielt hat, die Uhr 12 also mit ausgetauschter Batterie 14 wieder funktionstüchtig und dicht verschlossen ist.

Insbesondere bei flachen Armbanduhren 12 ist allerdings der für diesen Schnappvorgang anzustrebende deutliche Unterschied zwischen der Kragendicke 34 und der möglichst ausgeprägt größeren Steckteilhöhe 35 nicht ohne weiteres im angestrebten Maße realisierbar. In diesem Falle läßt sich jedoch das angestrebte Schnappverhalten dadurch fördern, daß eine - bezüglich der Dichtkante 32 konzentrisch ausgebildete -kalottenförmige Aushöhlung 36 in der rückwärtigen Druckfläche 37 ausgebildet wird, die wie eine Verringerung der Dicke 34 gegenüber der Höhe 35 wirkt.

Ebenfalls im Interesse einer Anpassung des Verhaltens der Materialverformung an die Montage- und Dichterfordernisse kann es zweckmäßig sein, wie in der Zeichnung aus Gründen der Übersicht nur beim unverformten Stopfen 18 strichliert berücksichtigt, wenigstens eine Ausnehmung 38 in der Stopfen-Stirnfläche 21 vorzusehen, die beispielsweis einen stehenbleibenden Andruckstempel 39 zur zentralen axialen Batterie-Abstützung grabenförmig umgibt.

Da der mechanisch feste und wasserdichte Verschluß der Batteriekammer-Öffnung 15 durch die radiale, elastisch-verformte Anlage der Steckteil-Mantelfläche 25 gegen die Dichtkante 32 gewährleistet sein muß, ist für das Material des Stopfens 18 vorzugsweise ein hoch-dauerstandfester Kunststoff mit gutem Rückfederungsverhalten bei überdurchschnittlicher Material-Zähigkeit zu wählen. Ein alle diese Eigenschaften aufweisendes und dabei gut im Spritzguß verarbeitbares Material ist etwa das insbesondere für elektrische Isolierungen unter der Handelsbezeichnung "Hytrel" von der Firma DuPont vertriebene Polyester-Elastomer. Als Kunststoff für die radiale Einfassung des Verschlußstopfens 18, also für den BatteriekammerBoden 11 bzw. für ein einstückig mit dem Boden 11 gespritztes Uhrgehäuse, wird dann, wegen der funktionnellen Paarung, vorzugsweise ein Material eingesetzt, das ebenfalls temperaturbeständig-dimensionsstabil ist; etwa wie es als thermoplastisches Ploycarbonat unter der Handelsbezeichnung "Macrolon" von der Firma Bayer, als Spritzgußmaterial für Präzisionsteile, vertrieben wird.

## Patentansprüche

1. Verschluß (10) für die im Boden (11) einer Armbanduhr (12) gelegene Batteriekammer-Öffnung (15) zum Austausch einer Batterie (14),
wobei die Öffnung (15) mit einer umlaufenden Dichtkante (32) ausgestattet ist,
in der ein Stopfen (18) mit einem an einen Kragen (23) sich anschließenden Steckteil (24) radial kraftschlüssig gehaltert ist,
dadurch gekennzeichnet,
daß der Stopfen (18) als mittig durchgebogenes Schnappelement aus steifelastischem Kunststoff ausgeführt
und sein Eingriff mit dem größeren Anteil seiner Höhe (35) durch die Öffnung (15) hindurch für axiale elastische Anlage jedenfalls des Mittenbereiches (19) seiner Stirnfläche (21) gegen die Rückseite (22) der Batterie (14) ausgelegt ist
wobei die an den Kragen (23) sich anschließende Mantelfläche (25) des Steckteils (24) dicht über dem Kragen (23) eine radiale Stauchung von der umlaufenden Dichtkante (32) erfährt, welche an der Stirn einer Rampe (26) ausgebildet ist, die ihrerseits die Öffnung (15) zum Innern hin konisch aufweitet und der gegenüber das Stopfenmaterial eine abdichtende elastische Verformung infolge der radialen Reaktionskräfte erfährt, die beim Ausbeulen des Verschluß-stopfens (18) von der Bodenfläche (28) fort zum Gehäuseinnern hin bis zur axialen Stütz-Anlage gegen die Batterie-Rückseite (22) auftreten.

2. Verschluß nach Anspruch 1,
dadurch gekennzeichnet,
daß die Dicke (34) seines gegen die Öffnungs-Dicntkante (32) anliegenden Kragens (33) höchstens so groß wie die axiale Höhe des in und durch die Öffnung (15) ragenden Steckteiles (24) ist.

3. Verschluß nach Anspruch 2
dadurch gekennzeichnet,
daß die für den Durchwölbe-Schnappvorgang maßgebliche wirksame Dicke (34) des Kragens (23), im Vergleich zur Höhe (35) des Stopfen-Steckteiles (24), durch eine Aushöhlung (36) in der Montage-Druckfläche (37) reduziert ist.

4. Verschluß nach einem der vorangehenden Ansprüche,
dadurch gekennzeichnet,
daß der Mittenbereich (19) der der Batterie (14) zugewandten Stirnfläche (21) des Stopfens (18) als von wenigstens einer Ausnehmung (38) in der Stopfen-Stirnfläche (21) umgebener Andruck-Stempel (39) ausgebildet ist.

5. Verschluß nach einem der vorangehenden An-sprüche,
dadurch gekennzeichnet,
daß der, etwa gegen die Öffnungs-Dichtkante (32) axial anliegende, Kragen (23) in einen Einstich (27) in der die Öffnung (15) umgebenden Bodenfläche (28) versenkt angeordnet ist.

6. Verschluß nach einem der vorangehenden Ansprüche,
dadurch gekennzeichnet,
daß der Stopfen-Kragen (23) in ein Steckteil (24) mit zylindrischer Mantelfläche (25) übergeht, die ihrerseits zur Stopfen-Stirnfläche (21) hin in eine Einführ-Verjüngung (31) übergeht.

## Claims

1. Closure (10) for the battery-chamber opening (15), located in the back cover (11) of a wristwatch (12), for replacing a battery (14),
the opening (15) being provided with a surrounding sealing edge (32),
in which a stopper (18) having a push-in portion (24) adjoining a collar (23) is held radially in a non-positive way,
characterized in that
the stopper (18) is made as a snap-in element which sags in the middle and is made of stiffly elastic plastic,
and its engagement with the larger part of its height (35) through the opening (15) is designed for axial elastic location, at least of the central area (19) of its front surface (21), against the rear side (22) of the battery (14),
the external surface (25) of the push-in portion (24) adjoining the collar (23) being subjected just above the collar (23) to a radial compression by the surrounding sealing edge (32) which is formed at the front of an incline (26), which for its part conically widens the opening (15) towards the interior and against which the stopper material undergoes a sealing elastic deformation as a result of the radial reaction forces which occur when the closure stopper (18) bulges away from the back surface (28) towards the interior of the case until axially supported against the rear side (22) of the battery.

2. Closure according to Claim 1,
characterized in that
the thickness (34) of its collar (33) resting against the opening's sealing edge (32) is at most as great as the axial height of the push-in portion (24) which projects into and through the opening (15).

3. Closure according to Claim 2,
characterized in that
the effective thickness (34) of the collar (23) crucial for the curving snap-in action is reduced, compared with the height (35) of the stopper's push-in portion (24), by a recess (36) in the assembly pressure area (37).

4. Closure according to one of the preceding claims,
characterized in that
the central area (19) of the front surface (21) of the stopper (18) facing the battery (14) is designed as a pressure support (39) surrounded by at least one recess (38) in the stopper's front surface (21).

5. Closure according to one of the preceding claims,
characterized in that
the collar (23), approximately resting axially against the opening's sealing edge (32), is disposed so as to be flush in a recess (27) in the back surface (28) surrounding the opening (15).

6. Closure according to one of the preceding claims,
characterized in that
the stopper's collar (23) changes into a push-in portion (24) with cylindrical external surface (25) which in its turn, towards the stopper's front surface (21), changes into a lead-in taper (31).

## Revendications

1. Obturateur (10) pour l'ouverture (15) d'un logement d'une pile situé dans le fond (11) d'un bracelet-montre (12), pour l'échange d'une pile (14), l'ouverture (15) étant équipée d'un bord d'étanchéité (32) périphérique, dans lequel un bouchon (18) avec une partie d'enfichage (24), se raccordant à un collet (23), est maintenu radialement à force, caractérisé en ce que le bouchon (18) est réalisé en tant qu'élément à encliquetage courbé au centre, en matière plastique semi-élastique, et en ce que son engagement à travers l'ouverture (15) par la plus grande partie de sa hauteur (35) est dimensionné pour l'application élastique axiale en tout cas de la zone centrale (19) de sa face frontale (21) contre la face arrière (22) de la pile (14), la surface d'enveloppe (25) de la partie d'enfichage (24), qui se raccorde au collet (23), subissant, juste au-dessus du collet (23), une compression radiale de la part du bord d'étanchéité (32) périphérique, lequel bord est formé à l'avant d'une rampe (26), qui de son côté élargit coniquement l'ouverture (15) vers l'intérieur et à l'écart de laquelle le matériau du bouchon subit une déformation élastique assurant l'étanchéité par suite des forces radiales de réaction qui surviennent lorsque le bouchon de fermeture (18) se bombe depuis la surface de fond (28) vers l'intérieur du boîtier, jusqu'au contact d'appui axial contre la face arrière (22) de la pile.

2. Obturateur selon la revendication 1, caractérisé en ce que l'épaisseur (34) de son collet (33), qui s'applique contre le bord d'étanchéité (32) de l'ouverture, est au maximum égale à la hauteur axiale de la partie d'enfichage (24) qui pénètre dans l'ouverture (15).

3. Obturateur selon la revendication 2, caractérisé en ce que l'épaisseur active (34) du collet (23) qui est détermininante dans le processus d'encliquetage par incurvation, est réduite, par rapport à la hauteur (35) de la partie d'enfichage (24) du bouchon, grâce à un creux (36) pratiqué dans la surface de pression de montage (37).

4. Obturateur selon l'une des revendications précédentes, caractérisé en ce que la zone centrale (19) de la face frontale (21) du bouchon (18), tournée vers la batterie (14), est réalisée sous la forme d'un poussoir de pressage (39) entouré par au moins un évidement (38) ménagé dans la face frontale (21) du bouchon.

5. Obturateur selon l'une des revendications précédentes, caractérisé en ce que le collet (23), qui s'appuie légèrement axialement contre le bord d'étanchéité (32) de l'ouverture, est encastré dans une encoche (27) pratiquée dans la surface de fond (28) entourant l'ouverture (15).

6. Obturateur selon l'une des revendications précédentes, caractérisé en ce que le collet (23) du bouchon se prolonge par une partie d'enfichage (24) avec surface d'enveloppe (25) cylindrique, qui de son côté se prolonge vers la face frontale (21) du bouchon par un rétrécissement d'introduction (31).
